# EUROPEAN PATENT APPLICATION

(11) **EP 0 681 295 A1**
(43) Date of publication of application: **08.11.1995**
(21) Application number: 94830214.6
(22) Date of filing: 06.05.1994
(51) Int. Cl.: G11C 16/00, G11C 29/00, G11C 16/06

(54) **Burn-in method for nonvolatile flash - EPROM memory devices**

(71) Applicant: SGS-THOMSON MICROELECTRONICS S.r.l., I-20041 Agrate Brianza (Milano) (IT)
(72) Inventor: Casagrande, Giulio, I-20060 Vignate (IT); Bacis, Guido, I-24049 Verdellino (IT); Golla, Carla Maria, I-20099 Sesto san Giovanni (IT)
(74) Representative: Cerbaro, Elena

(57) **Abstract**

A burn-in method for a number of memory devices, wherein sectors of the devices are subjected to a series of successive write and erase cycles in parallel, and the status registers of the devices are read sequentially. Each write and erase cycle is performed according to a control algorithm available in the logic part of each device, whereas the status registers are read externally to determine the test result and operation of the device. As such, the logic parts of the devices are also burnt-in, and the parts designed to operate at high voltage, at least in one operating mode, are high-voltage tested.

## Description

The present invention relates to a burn-in method for nonvolatile flash-EPROM memory devices.

As is known, electronic devices present a typical failure-time curve (known as a "bathtub" curve) which, from an initial maximum value for operating times below a first threshold, drops to a substantially constant value, and then increases once more after a second time threshold. The difference between the initial and typical value, prior to the second threshold, depends on various factors, and is normally greater in the case of new technology and/or particularly complex devices.

To improve the reliability of electronic devices and so prevent the marketing of devices subject to early failure (or what is generally referred to as "infantile mortality"), burn-in processes are adopted wherein the devices are so stressed as to cause those subject to premature failure to break down with substantially no damage to the others. The failed devices are then rejected by means of a diagnosis operation to ensure greater reliability of the others (expressed in terms of the number of failures within a predetermined period of time).

In the case of nonvolatile flash-EPROM memories, burn-in methods currently consist in performing a number of read operations under slightly higher than typical voltage and temperature conditions (e.g. 6-7 V and 125°C for devices designed to operate at 5 V and at temperatures below 55°C). For that purpose, the devices are mounted in parallel on a board and placed inside an oven; all the addresses are scanned successively using an external counter; numerous read cycles are normally performed for a total of 12-24 hours; and the devices are then tested to eliminate the failures.

Though widely used, the above burn-in and test method fails to provide for effectively eliminating premature breakdown components of modern second generation flash-EPROM memories, by failing to provide for testing the logic circuits forming the modification algorithms and control interface and which represent a significant part of such memories. Nor does it provide for testing the high voltage switch circuits, or for more than low-voltage testing of the actual memory part itself. As such, the above known burn-in method is far from satisfactory when applied to present flash memories.

It is an object of the present invention to provide a burn-in method designed to overcome the drawbacks and limitations typically associated with known methods, and which provides for more thorough testing of flash memories.

According to the present invention, there is provided a burn-in method for nonvolatile flash-EPROM memory devices, as claimed in Claim 1.

A preferred non-limiting embodiment of the present invention will be described by way of example with reference to the accompanying drawings, in which:
Figure 1 shows a block diagram of a typical nonvolatile flash-EPROM memory;
Figure 2 shows a flow chart of the method according to the present invention.

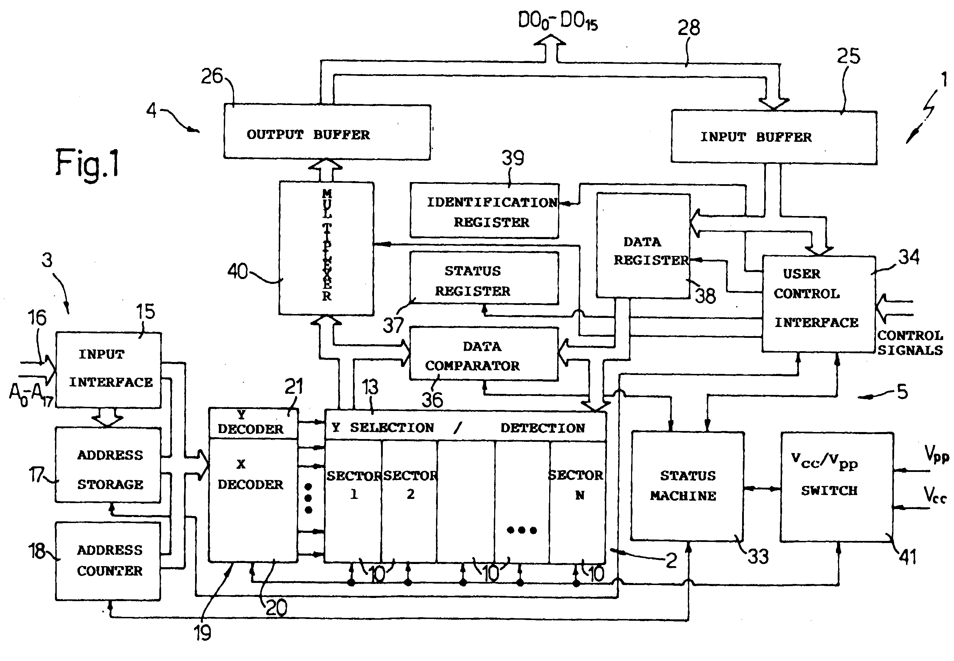

For a clearer understanding of the invention and the advantages afforded by it, Figure 1 shows a block diagram of a second generation flash memory device to which the method according to the present invention is applied.

The flash-EPROM memory device 1 in Figure 1 substantially comprises a memory array 2; an address control portion 3; an input/output interface portion 4; and a logic portion 5.

More specifically, memory array 2 comprises a number of blocks and sectors 10 and a selecting and detecting block 13. Address control portion 3 comprises an input interface block 15 connected to an external bus 16 supplying addresses A₀-A₁₇; an address storage block 17; an address counter 18; and a decoding block 19 including a row decoder 20 and a column decoder 21.

Input/output interface portion 4 comprises an input buffer block 25 and an output buffer block 26, both connected to a data bus 28 supplying data D₀-D₁₅.

Logic portion 5 comprises a status machine 33; a user control interface 34; a data comparator 36; a status register 37; a data register 38; an identification register 39; an output multiplexer 40; and a program/erase voltage switch 41.

Memory array 2 also comprises internal buses and data/command exchange lines shown in Figure 1 but not described in detail.

According to the known burn-in method, only blocks 15, 19, 2, 40 and 26 for scanning the addresses (generated externally) were read tested, the rest of device 1 being substantially untested.

According to one embodiment of the invention, the device is put through a number of successive write and erase cycles using the resources already available in the logic portion of the device; and the status register is read to determine the test result and operation of the device.

Like the known method, the burn-in method according to the invention is preferably applied simultaneously to a number of devices mounted in parallel on one or more boards; in which case, the same sectors of the test devices are written and erased in parallel, and the status register is read sequentially.

According to the present invention, write and erase checking of each sector is performed mainly using the internal logic of memory device 1 (status machine 33 and comparator 36); external logic only being used for generating the start signal, sequential acquisition of the content of the status registers of the various devices, and possibly also for evaluating the results (device diagnosis and reject signals).

More specifically, the following functions are performed internally: generation and control of write, erase and read-verify voltages; generation of memory sector and cell addresses in write, erase and verify mode; generation of the erase pulse sequence with erase-verify or erase-interrupt after an appropriate number of erase pulses; operation check (e.g. of the stability of supply voltage V_{PP}); and setting of the status register (e.g. of the end-of-erase bit relative to completion of the erase operation; of the erase status bit relative to the outcome of the erase operation; and of the bit VPP relative to stability of the supply voltage). The above operations may therefore be performed simultaneously (in parallel) by all the devices on the same board.

By writing and erasing memory array 2 and reading the status register, it is possible to test a much greater portion of memory device 1 as compared with the known method, as well as to high-voltage test any parts designed to operate at high voltage in at least one operating mode of device 1. In fact, the method described provides for low-voltage testing blocks 18, 25, 26, 33-37 and 40, and for high-voltage testing blocks 2, 19 and 41.

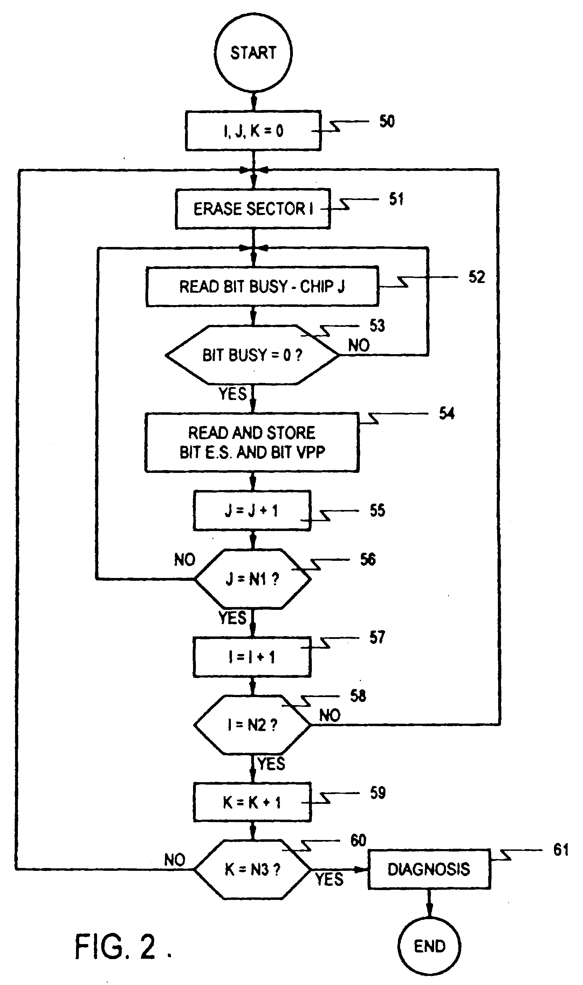

Figure 2 shows a flow chart of one embodiment of the method according to the present invention, assuming burn-in of N1 memory devices 1, each composed of N2 sectors, and assuming performance of N3 write/erase/register read cycles. In Figure 2, I, J and K indicate three counters relative to the number of sectors, devices and cycles respectively; and the operations controlled by the internal logic of each device are separated from those performed by the external logic which coordinates burn-in of all the devices and provides for diagnosing operation or failure of each device according to the reading of the status registers.

As shown in Figure 2, after assembling devices 1 on to boards (not shown), placing them inside an oven (possibly identical to those used at present), and initializing counters I, J and K (block 50), a command is generated to erase the I-th sector (block 51) of all the devices in parallel by means of the internal logic of each device which, prior to erase/verify, already provides for an all-"zero" write/verify operation. These operations are generally performed at higher than ambient temperature, e.g. 125°C, as in the known method. The end-of-erase bit (bit busy) of each device is then read sequentially, for which purpose, the bit busy of the J-th device is read (block 52) and a check made (block 53) to determine the end-of-erase logic state (e.g. "0") of the bit. In the event of a positive response, the bits E.S. and VPP are read and stored, and the value of the bits is set by the internal logic of each device (in known manner, block 54) at the end of the erase operation to indicate successful or unsuccessful termination of the erase operation and whether or not any interference has been encountered on the supply line. Conversely, in the event of a negative response, block 53 goes back to block 52 to await the end of the erase operation or at any rate the maximum number of erase attempts provided for by the internal logic of each device.

Reading of the status register as described above (blocks 52-54) is repeated for all the devices, the device counter J being incremented each time (block 55), and a check being made (block 56) to determine whether or not the number N1 of burnt-in devices for each board has been reached. Upon the status registers of all the devices being read, the write, erase and status register sequential read operations are repeated for the next sectors, as shown in Figure 2 by block 57 which provides for incrementing sector counter I, and by block 58 which determines whether counter I has reached the number N2 of sectors into which the tested memory devices are divided.

The above cycle of write, erase and status register read operations is repeated a predetermined number of times (or for a predetermined length of time) as shown in Figure 2 by block 59 which provides for incrementing cycle counter K, and by block 60 which determines whether counter K has reached the allotted number N3 of cycles. Finally (block 61), the external logic or other processing system performs a diagnosis routine using the stored values of the previously read status registers, to distinguish between the failed devices for elimination, and the successfully burnt-in devices, thus terminating the procedure.

The advantages of the method described are as follows. Firstly, it provides for also stressing and testing the logic parts of the memory device, thus permitting testing of a greater portion of the device as compared with known methods. Secondly, by virtue of the high-voltage operations performed, the method according to the present invention provides not only for testing and stressing formerly neglected parts, but also for more thoroughly testing both low- and high-voltage parts, testing of which was formerly limited to only one of the two operating modes. This is particularly advantageous in the case of new devices or devices based on new technologies, by enabling information to be obtained with which to perfect and/or correct the devices or technologies employed.

Thirdly, in view of the improved characteristics of the present invention as compared with the known method, in the case of devices based on proven technologies with an already fairly high degree of reliability (below average infantile mortality rate), it provides for reducing burn-in time for a given final degree of reliability of the device.

Finally, by using the same ovens and simply adapting the component boards and control operations, the cost of the method according to the present invention is comparable with that of the known method.

Clearly, changes may be made to the method as described and illustrated herein without, however, departing from the scope of the present invention. In particular, the flow chart described is purely indicative, and the diagnosis and status register read operations, for example, may be performed at times other than those described.

## Claims

1. A burn-in method for a nonvolatile flash-EPROM memory device, comprising the steps of stressing the memory device (1) for a predetermined time, and determining operation of the device; characterized in that said step of stressing the device comprises the step of subjecting the memory device to a number of write and erase cycles.

2. A burn-in method for a number of memory devices as claimed in Claim 1, characterized in that it comprises the step of subjecting the memory devices (1) in parallel to a number of write and erase cycles.

3. A method as claimed in Claim 2, characterized in that said step of determining operation comprises the step of sequentially reading status register (37) regions of the memory devices (1).

4. A method as claimed in Claim 3, characterized in that each write and erase cycle comprises the steps of:
a) performing a write and erase cycle in parallel in a predetermined sector of the memory devices (1);
b) sequentially reading the status register (37) regions of the memory devices; and
c) repeating steps a) and b) for all the sectors of the memory devices.

5. A method as claimed in Claim 4, characterized in that said step a) comprises the steps of:
a1) generating an erase pulse;
a2) verifying erasure;
a3) selectively performing the step of:
repeating steps a1), a2) in the event of non-erasure, or
entering an end-of-erase variable in the event of erasure;
and in that said step b) comprises the steps of:
b1) reading said end-of-erase variable;
b2) selectively performing the step of:
waiting a predetermined time and repeating step b1) in the event said variable presents a first value, or
reading correct operation information in said status register (37) in the event said variable presents a second value.

6. A method as claimed in Claim 4 or 5, characterized in that said step of reading correct operation information comprises the steps of reading an erase status bit and an enabling voltage stability bit.

7. A method as claimed in one of the foregoing Claims from 4 to 6, characterized in that said step a) is controlled internally and simultaneously by the memory devices (1).
